# FASCICULE DE BREVET EUROPEEN

(11) **EP 2 359 414 B1**
(45) Date de publication et mention de la délivrance du brevet: **15.02.2017**
(21) Numéro de dépôt: 09768376.7
(22) Date de dépôt: 08.12.2009
(51) Int. Cl.: H01L 31/105, H01L 31/0304

(54) **DETECTEUR INFRAROUGE A REPONSE SPECTRALE ETENDUE DANS LE VISIBLE**
INFRAROTDETEKTOR MIT ERWEITERTEM SPEKTRALEN ANSPRECHVERHALTEN IM SICHTBAREN FELD
INFRARED DETECTOR WITH EXTENDED SPECTRAL RESPONSE IN THE VISIBLE FIELD

(30) Priorité: 12.12.2008 FR 0806997
(43) Date de publication de la demande: 24.08.2011
(73) Titulaire: Société Française de Détecteurs Infrarouges - SOFRADIR, 91120 Palaiseau (FR)
(72) Inventeur: BOIS, Philippe, 77240 Cesson (FR); PARILLAUD, Olivier, 91190 Gif-sur-Yvette (FR); MARCADET, Xavier, 91120 Palaiseau (FR); PAPUCHON, Michel, 91140 Villebon/Yvette (FR)
(74) Mandataire: Cabinet Laurent & Charras
(86) Numéro de dépôt international: PCT/EP2009/066632
(87) Numéro de publication internationale: WO 2010/066735

(56) Documents cités:
- US-B1- 6 740 908
- "Handbook of PHOTONICS", 1997, MOOL C. GUPTA, CRC PRESS LLC, BOCA RATON, FLORIDA, USA. ISBN 0-8493-8909-7, XP002548459, page 18, ligne 33
- ANDREEV I A ET AL: "ULTRAFAST GAINASSB P-I-N PHOTODIODE FOR THE SPECTRAL INTERVAL 1.5-2.3 M", SOVIET TECHNICAL PHYSICS LETTERS, AMERICAN INSTITUTE OF PHYSICS. NEW YORK, US, vol. 15, no. 4, 1 avril 1989 (1989-04-01), page 253/254, XP000102642,

## Description

Le domaine de l'invention est celui des détecteurs infrarouge et plus particulièrement celui des matrices de détecteurs infrarouge à multipuits quantiques, conçus notamment pour être exploités dans des systèmes optroniques.

L'invention concerne plus précisément des photodétecteurs de type diodes PIN dans le domaine « SWIR » (Short Wavelength Infrared Detector), typiquement, il s'agit de longueurs d'onde inférieures à environ 2,5 µm.

On définit classiquement les différents domaines de détection infrarouge comme suit : les détecteurs du domaine SWIR, ceux du domaine « MWIR » (Middle Wavelength Infrared Dectector) dans la gamme 3-5 µm et ceux du domaine « LWIR » (Long Wavelength Infrared Detector) dans la gamme de longueurs d'onde 8-12 µm.

Il existe actuellement des détecteurs infrarouge constitués de photodiodes PIN destinées à la détection infrarouge de type « SWIR » pouvant être réalisées à partir d'une couche active non dopée en In₁₋ₓGaₓAs contactée par deux couches dopées respectivement n et p, en InP.

Plus particulièrement, il a déjà été proposé des diodes PIN avec des matériaux de type HgCdTe ou In_{.47}Ga_{.53} As comme couche active dans ce domaine de longueurs d'onde, pour lesquels la largeur de bande interdite définit de manière intrinsèque, la longueur d'onde de coupure haute λc (cut-off). Ces détecteurs n'ont pas de longueur d'onde de coupure basse (cut-on) et doivent donc détecter tout le spectre électromagnétique en deçà de λc, et en particulier le rayonnement visible.

L'invention concerne l'extension en longueur d'onde du domaine de détection spectrale de ces détecteurs, qui est généralement limité par le gap de la couche active (λ_{cut-off}) et par l'absorption du substrat et/ou de la couche fenêtre résiduelle (λ_{cut-on}).

De manière générale, les détecteurs infrarouge de type diode PIN sont des détecteurs matriciels hybridés sur un circuit de lecture silicium multiplexés qui nécessitent une illumination par la face arrière, à travers la couche de contact inférieur.

La couche de contact inférieur (couche généralement semi-conductrice dopée n) est une couche dite fenêtre pour le rayonnement SWIR à détecter mais absorbe le rayonnement visible, diminuant ainsi la part du flux incident qui peut être absorbée dans la couche utile de la diode (zone non dopée).

En général, les différents matériaux utilisés sont des semiconducteurs à gap direct, avec des coefficients d'absorption très supérieurs à 10⁴cm⁻¹ dans cette partie du spectre.

Typiquement pour une diode PIN à base de InP, à une longueur d'onde de fonctionnement λ = 0,6 µm, la valeur du coefficient d'absorption est de 6.7 10⁴cm⁻¹. Ceci limite considérablement le rayonnement incident dans la zone active. En effet, l'épaisseur de cette couche doit être suffisante pour assurer un contact homogène (typiquement cette épaisseur doit être au moins supérieure à environ 300 nm), ce qui conduit déjà à une extinction de 86%.

Le brevet US6740908 et l'article "Ultrafast GaInAsSb p-i-n photodiode for the spectral interval 1.5-2.3 µm", A. Andreev et al., Soviet Technical Physics Letters 15(4), April 1989, pages 253-254 décrivent un détecteur de type SWIR comprenant un contact servant de fenêtre optique en AlGaAsSb.

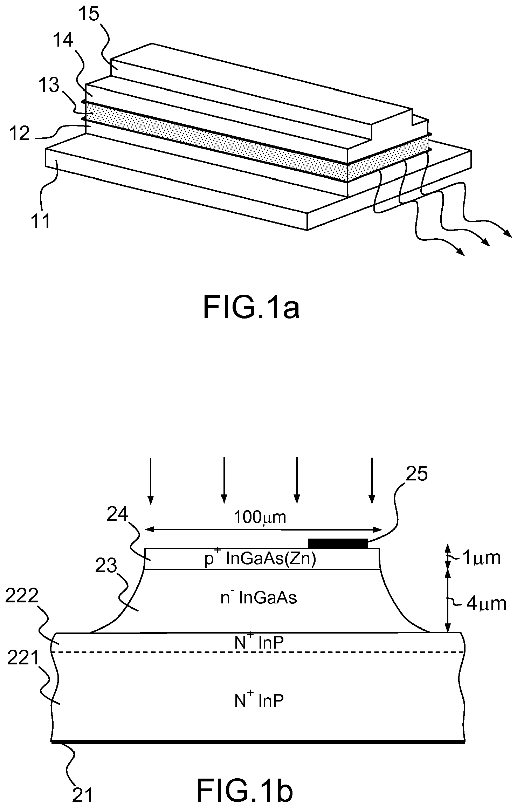

La figure 1a illustre un schéma de diode PIN très général, la figure 1b illustrant une diode PIN selon l'art connu en GaInAs/InP.

De manière générale, une zone active 13 en matériau semiconducteur non dopé est insérée entre une couche 12 en matériau semiconducteur dopé n et une couche 14 en matériau semiconducteur dopé p, l'ensemble étant intégré entre une électrode inférieure 11 et une électrode supérieure 15.

Un exemple de structure est illustré en figure 1b. Une électrode en face arrière 21 supporte un substrat 221 en InP dopé N⁺ recouvert d'une couche 222 en InP dopé N⁺. La couche active de détection 23 est en InGaAs. La couche active est recouverte d'une couche 24 en InGaAs (Zn) dopé p⁺. Un contact 25 en Ti/Au est réalisé au dessus de cette couche dopée p⁺. Des exemples de dimensions sont représentés sur cette figure 1 b.

Une solution actuellement retenue pour réaliser ce type de détecteurs infrarouge consiste d'une part à éliminer le substrat et d'autre part surtout à limiter une partie de l'épaisseur de la couche de contact.

En raison de la fonction électrique de cette couche de contact, il n'est pas possible de la réduire suffisamment, car il faut assurer un contact homogène. Pour une valeur "raisonnable" de l'ordre de 200 nm, le facteur d'extinction est déjà de 74% dans un matériau tel que InP à 0.6µm. En pratique, l'efficacité quantique d'une photodiode GaInAs/InP optimisée est de 85% dans le SWIR et seulement de 30% à 0.6µm et devient proche de 0 à 450 nm.

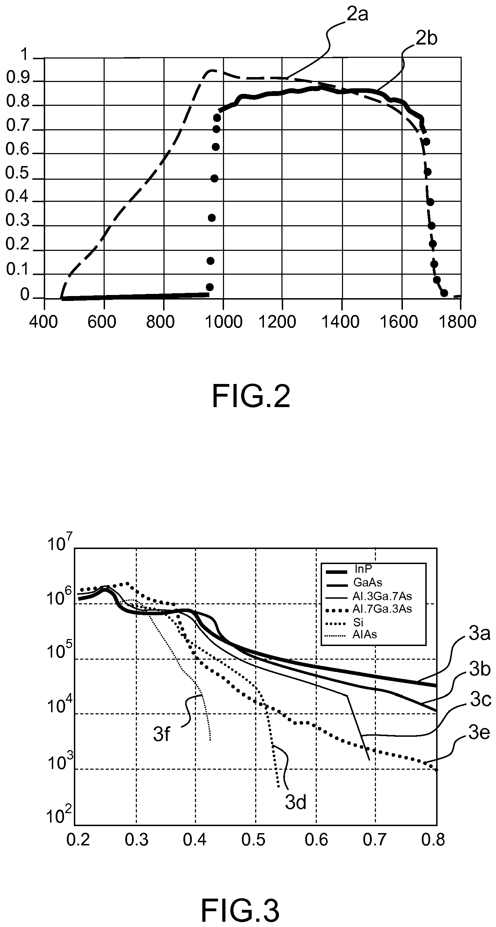

A ce titre, la figure 2 illustre la réponse spectrale d'un exemple d'un détecteur de type Goodrich. La courbe 2a est relative à la réponse d'un détecteur étendu dans le domaine du visible, la courbe 2b est relative à la réponse du détecteur standard dans le domaine du SWIR.

Pour limiter de manière notable le phénomène d'absorption de la couche de contact inférieur dans le domaine visible, source de diminution de performance du détecteur en raison de la diminution de la part de flux incident pouvant être absorbée par la couche sensible, il est proposé dans la présente invention de réaliser un contact électrique en matériau à gap indirect, remplaçant ainsi avantageusement le contact inférieur électrique en matériau à gap direct actuellement utilisé dans les détecteurs infrarouge du domaine « SWIR ».

Dans la famille des matériaux semiconducteurs, la notion de gap direct et de gap indirect est liée à la représentation de la dispersion énergétique du matériau semiconducteur concerné, donnant le diagramme de l'énergie E en fonction du vecteur d'onde k. Ce diagramme permet de définir spatialement les extrema des bandes de conduction et de valence. Ces extrema représentent, dans un matériau semiconducteur des domaines énergétiques où la densité de porteurs de type p pour la bande de valence et de porteurs de type n pour la bande de conduction, sont importants.

On parle de semiconducteur à gap direct, pour un semiconducteur dont le maximum de la bande de valence et le minimum de la bande de conduction se situent à une valeur voisine du vecteur d'onde k sur le diagramme E(k).

On parle de matériau semiconducteur à gap indirect, pour un semiconducteur dont le maximum de bande de valence et le minimum de la bande de conduction se situent à des valeurs distinctes du vecteur d'onde k sur le diagramme E(k).

Il est à noter que la plupart des matériaux issus des colonnes III et V du tableau périodique des éléments chimiques sont des matériaux à gap direct, alors que le silicium appartenant à la colonne IV du tableau périodique des éléments chimiques est à gap indirect.

Plus précisément la présente invention a pour objet un détecteur infrarouge à base de matériaux semiconducteurs, de type SWIR sensible à des longueurs d'onde inférieures à environ 2.5 microns comportant un empilement de couches semiconductrices à base de matériaux III-V constituant une photodiode de type PIN, ledit empilement comprenant au moins :
- un contact électrique dit inférieur servant de fenêtre optique;
- une couche de détection sensible auxdites longueurs d'ondes ;
caractérisé en ce que le contact dit inférieur étant à nu comporte au moins une couche de matériau(x) III-V à gap indirect dopée n de type pseudomorphique ou accordé(s) en maille avec un substrat constitué de matériau III-V InP ou GaAs, ou d'un matériau Silicium ou Germanium.

Selon une variante de l'invention, la couche de détection est en GaInAs.

Selon une variante de l'invention, le contact dit inférieur comporte un alliage à base de (Al,As,Sb).

Selon une variante de l'invention, le contact dit inférieur comporte un alliage de AlAs 0,563 Sb 0.437.

Selon une variante de l'invention, le contact dit inférieur comporte au moins une alternance de couches de type (Al,Ga)AsSb/(Al,Ga)InAs ou plus précisément AlₓGa₁₋ₓAsₜSb₁₋ₜ 1 (Al_{y}Ga_{1-y})_{1-z}In_{z}As. Selon une variante de l'invention, l'alternance de couches constituant le contact dit inférieur comporte au moins une dizaine de paires de couches de type (Al,Ga)AsSb (AlₓGa₁₋ₓAsₜSb₁₋ₜ)et de type (AlGa)InAs ((Al_{y}Ga_{1-y})_{1-z}In_{z}As).

Selon une variante de l'invention, le détecteur infrarouge comporte en outre une couche d'adaptation de bande de conduction entre le contact dit inférieur et la couche sensible.

Selon une variante de l'invention, la couche d'adaptation comporte un ensemble de couches élémentaires d'adaptation comprenant une alternance de couches de type (Al,Ga)AsSb/(Al,Ga)InAs.

Selon une variante de l'invention, la couche de détection est en GaAs (λ<850 nm). Selon une variante de l'invention, la couche de détection est en InP (λ<920 nm).

Selon une variante de l'invention, le contact dit inférieur comporte au moins une couche d'alliage AlₓGa₁₋ₓ As avec x compris entre 0,42 et 1.

L'invention a aussi pour objet un procédé de fabrication d'un détecteur infrarouge de type SWIR selon l'invention, caractérisé en ce qu'il comporte les étapes suivantes :
- la réalisation à la surface d'un substrat de type InP, d'un contact électrique dit inférieur comprenant au moins une couche à gap indirect ;
- la réalisation d'une couche de détection à la surface du contact électrique dit inférieur ;
- la réalisation d'une couche en matériau semiconducteur dopé p et d'un contact électrique dit supérieur ;
- le retrait dudit substrat de l'empilement préalablement réalisé.

L'invention sera mieux comprise et d'autres avantages apparaîtront à la lecture de la description qui va suivre donnée à titre non limitatif et grâce aux figures annexées parmi lesquelles :
- les figures 1a et 1b illustrent un schéma général de diode PIN et celui d'une diode en GaInAs/InP selon l'art connu ;
- la figure 2 illustre la réponse spectrale d'un détecteur de type Goodrich de l'art connu correspondant à la structure illustrée en figure 1b;
- la figure 3 illustre l'évolution de l'absorption en fonction de la longueur d'onde pour différents type de matériaux semiconducteurs InP, GaAs, Al_{0.3}Ga_{0.7}As (à gap direct) et Si, AlAs, Al_{0.7}Ga_{0.3}As (gap indirect) ;
- la figure 4 illustre le gap d'énergie en fonction du paramètre de maille pour différents alliages de matériaux semiconducteurs susceptibles d'être utilisés dans un détecteur infrarouge de l'invention ;
- la figure 5 illustre un schéma d'un super-réseau AlAsSb/InGaAs constituant un contact électrique inférieur en accord de maille avec un substrat InP selon l'invention ;
- la figure 6 illustre un schéma de bandes d'une diode SWIR selon invention ;
- la figure 7 illustre un exemple de plan focal de détection selon l'invention.

De manière générale, le détecteur infrarouge de la présente invention comprend un contact électrique dit inférieur servant de fenêtre au rayonnement à détecter. Ce contact comprend des couches constituées de matériau à gap indirect, soit en totalité soit partiellement en vue de réduire leur coefficient d'absorption dans le visible.

En effet l'efficacité des transitions optiques dans un semiconducteur à gap indirect est moins forte que dans le cas des semiconducteurs à gap direct, si on reste en deçà du spectre UV.

A titre d'exemple pour des matériaux semiconducteurs tels que InP ou GaAs, à gap direct, le coefficient d'absorption est respectivement de 6.7 10⁴cm⁻¹ et 4.7 10⁴cm⁻¹ à 0.6µm, alors que ce coefficient est égal à 410³cm⁻¹ pour le silicium, matériau semiconducteur à gap indirect.

La figure 3 illustre l'évolution de l'absorption en fonction de la longueur d'onde pour différents matériaux semiconducteurs InP, GaAs, Al_{.3}Ga_{.7}As à gap direct (courbes pleines 3a, 3b, 3c) et Si, AlAs, Al_{0.7}Ga_{0.3}As à gap indirect (courbes pointillées 3d, 3e, 3f).

### Exemple de réalisation d'un détecteur IR fonctionnant dans le domaine «SWIR»

Le détecteur infrarouge est réalisé à partir d'un substrat en InP comportant au moins le contact dit inférieur, la couche sensible au rayonnement à détecter et une couche de matériau semiconducteur dopée p et un contact dit supérieur.

Le substrat est retiré dans un second temps, pour laisser à nu le contact dit inférieur destiné à servir de fenêtre optique.

Dans la colonne des matériaux III-V, certains matériaux possèdent un gap indirect et sont accordés en maille avec un substrat de type InP, afin de garantir un matériau non contraint et/ou avec une densité de défauts compatible de la fabrication de matrices de détecteurs multi-éléments (comportant typiquement au moins 100 000 pixels).

Parmi ces matériaux, on trouve notamment le matériau AlAs_{0.563}Sb_{0.437} :
- pour des raisons métallurgiques, il est plus facile de faire croître un "pseudo-alliage" (Al,Ga)AsSb/(AlGa)InAs que le matériau AlAsSb massif ;
- pour adapter les bandes de conduction de la couche contact et de la couche active, il est possible également d'utiliser une couche graduelle de "pseudo-alliage" (AlGa)AsSb/(AlGa)InAs, qui assure la même fonction que celle d'une couche d'adaptation standard en GaInAsP.

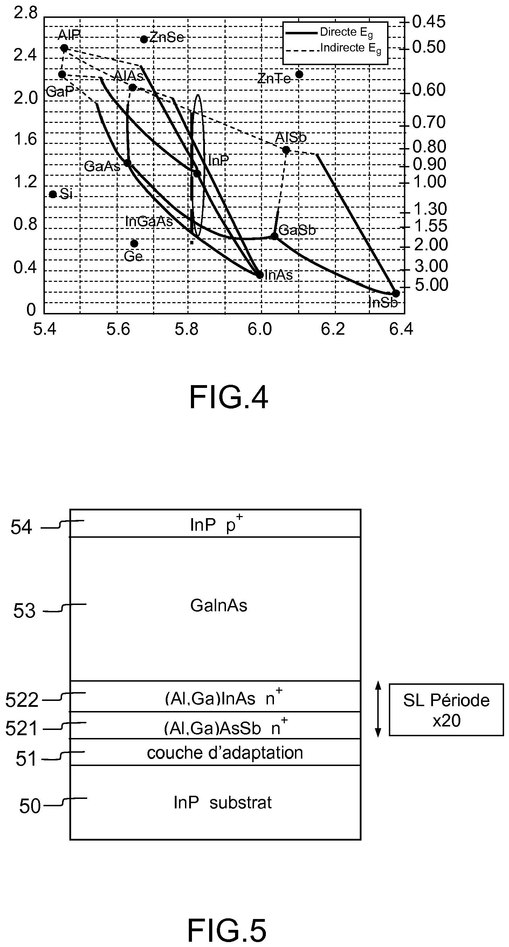

La figure 4 illustre l'évolution de l'énergie du gap entre bande de valence et bande de conduction en fonction du paramètre de maille pour différents matériaux semiconducteurs III-V.

Selon une variante de l'invention, il est proposé de réaliser ainsi des pseudo-alliages en utilisant des super-réseaux constitués de couches AlAsSb et GaInAs accordés en maille sur le substrat InP, en faisant varier la proportion relative des deux matériaux pour reproduire le profil de bande standard.

Ces super-réseaux sont à gap direct ou indirect selon leur composition.

Le résultat est une couche contact dont une partie seulement demeure à gap direct, ce qui conduit à en diminuer le coefficient global d'absorption.

La figure 5 illustre un schéma d'un super-réseau AlAsSb/InGaAs en accord de maille sur InP utilisé dans cet exemple de détecteur selon l'invention.

Sur un substrat 50 en InP, on réalise une couche intermédiaire 51 dite d'adaptation en GaInAsP. A la surface de cette couche on réalise la structure dite super-réseau SL comportant une alternance de paires 521 et 522 de couches en (AI,Ga)AsSb et en (Al,Ga)InAs, la structure comportant typiquement une vingtaine de paires SL de couches, l'épaisseur totale de la structure dite super-réseau étant de 330 nm. A la surface de cette structure est réalisée la couche active 53 en GaInAs, puis la couche contact supérieur 54 en InP dopée p+.

Afin d'obtenir un pseudo-alliage possédant un gap indirect, la couche d'adaptation de GaInAsP peut être remplacée par de l'(AlGa)InAs. Les épaisseurs des puits et des barrières sont à ajuster afin d'obtenir un pseudo-alliage et non l'empilement de deux matériaux.

Pour adapter les bandes de conduction de la couche contact et de la couche active, les compositions des couches peuvent être modifiées de période en période.

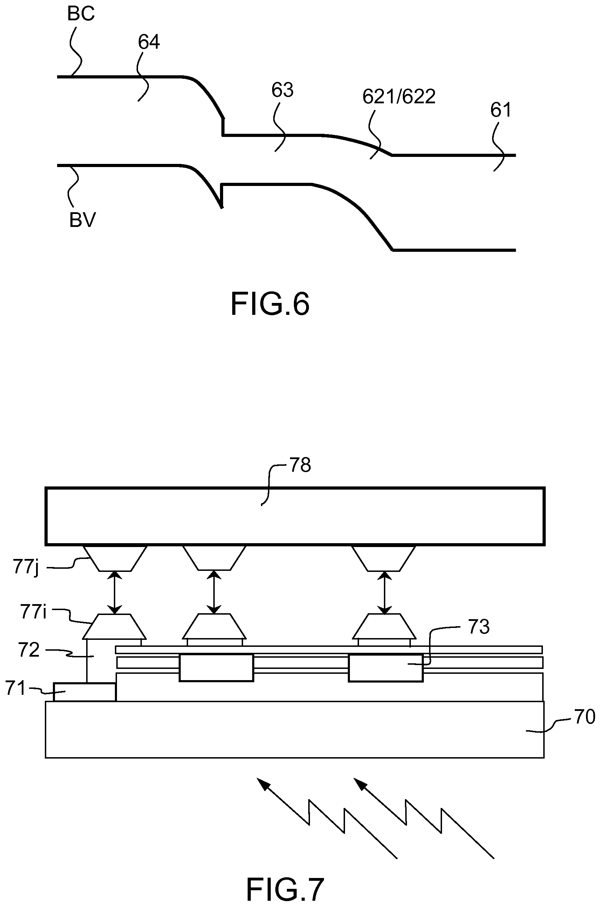

La figure 6 illustre un schéma de bande de conduction BC et de bande de valence BV, d'un exemple de détecteur de type SWIR comportant respectivement un substrat 60 en InP dopé n, une structure de super-réseaux à base de AlGaInAsSb dopé n, 621/622, d'une couche active non dopée 63 de GaInAs et d'une couche supérieure 64 InP dopée p.

Il suffit, après la croissance et la fabrication d'une matrice et après l'assemblage d'un plan focal (le plan focal étant défini de manière connue par l'ensemble hybride constitué par une matrice de pixels et un multiplexeur ou circuit de lecture silicium) d'éliminer le substrat d'InP pour obtenir un plan focal SWIR, dont l'efficacité quantique est préservée jusque dans le domaine des longueurs d'onde visible (soit jusqu'à environ 0.4 µm).

La figure 7 donne un exemple de réalisation d'un tel assemblage hybride constituant un plan focal de détection.

De manière connue, un substrat 70 de type InP supporte les pixels actifs 73 identiques à ceux décrits en figure 5, via des contacts non représentés et sont solidarisés à une matrice de lecture 78 par l'intermédiaire de billes d'Indium 77ᵢ et 77ⱼ. Le contact de type N est repéré par la référence 71, et peut avantageusement être connecté à une bille d'indium via un élément métallique 72.

### Exemple de détecteur infrarouge fonctionnant dans le domaine NIR (longueur d'onde de coupure λ_{c}≈ 0.9µm)

Le détecteur infrarouge comporte une couche sensible en InP ou en GaAs.

Dans le cas d'un détecteur sur substrat InP, le contact dit inférieur est avantageusement réalisé avec un matériau à gap indirect du type (AlGaIn)(AsSb) décrit plus haut dans l'invention.

Dans le cas d'un détecteur sur substrat GaAs, le contact dit inférieur est avantageusement réalisé avec un matériau à gap indirect de type

AlₓGa₁₋ₓAs, avec x compris entre 0,42 et 1. Pour des fractions molaires inférieures, l'alliage est un matériau à gap direct présentant une trop forte absorption.

## Revendications

1. Détecteur infrarouge à base de matériaux semiconducteurs, de type SWIR sensible à des longueurs d'onde inférieures à environ 2.5 microns comportant un empilement de couches semiconductrices à base de matériaux III-V constituant une photodiode de type PIN, ledit empilement comprenant au moins :
- un contact électrique dit inférieur servant de fenêtre optique;
- une couche de détection sensible auxdites longueurs d'ondes ;
**caractérisé en ce que** le contact dit inférieur est à nu et comporte au moins une couche de matériau(x) III-V à gap indirect dopée n de type pseudomorphique ou accordé(s) en maille avec un substrat constitué de matériau III-V InP ou GaAs, ou d'un matériau Silicium ou Germanium.

2. Détecteur infrarouge selon la revendication 1, **caractérisé en ce que** la couche de détection est en GaInAs.

3. Détecteur infrarouge selon la revendication 2, **caractérisé en ce que** le contact dit inférieur comporte un alliage à base de (Al,As,Sb).

4. Détecteur infrarouge selon la revendication 2, **caractérisé en ce que** le contact dit inférieur comporte un alliage de AlAs_{0,563}Sb_{0,437}.

5. Détecteur infrarouge selon la revendication 3, **caractérisé en ce que** le contact dit inférieur comporte au moins une alternance de couches de type (Al,Ga)AsSb/(AlGa)InAs.

6. Détecteur infrarouge selon la revendication 5, **caractérisé en ce que** l'alternance de couches comporte au moins une dizaine de paires de couches de type (AI,Ga)AsSb et de type (AlGa)InAs.

7. Détecteur infrarouge selon l'une des revendications 1 à 6, **caractérisé en ce qu'**il comporte en outre une couche d'adaptation de bande de conduction entre le contact dit inférieur et la couche sensible.

8. Détecteur infrarouge selon la revendication 7, **caractérisé en ce que** la couche d'adaptation comporte un ensemble de couches élémentaires d'adaptation comprenant une alternance de couches de type (Al,Ga)AsSb/(Al,Ga)InAs.

9. Détecteur infrarouge selon la revendication 1, **caractérisé en ce que** la couche de détection est en GaAs.

10. Détecteur infrarouge selon la revendication 1, **caractérisé en ce que** la couche de détection est en InP.

11. Détecteur infrarouge selon la revendication 9, **caractérisé en ce que** le contact dit inférieur comporte au moins une couche d'alliage AlₓGa₁₋ₓ As avec x compris entre 0,42 et 1.

12. Détecteur infrarouge selon la revendication 10, **caractérisé en ce que** le contact dit inférieur comporte un alliage à base de (Al,As,Sb).

13. Détecteur infrarouge selon la revendication 10, **caractérisé en ce que** le contact dit inférieur comporte un alliage de AlAs_{0,563}Sb_{0,437}.

14. Détecteur infrarouge selon la revendication 10, **caractérisé en ce que** le contact dit inférieur comporte au moins une alternance de couches de type (Al,Ga)AsSb/(AlGa)InAs.

15. Détecteur infrarouge selon la revendication 10, **caractérisé en ce que** le contact dit inférieur comporte au moins une dizaine de paires de couches de type (Al,Ga)AsSb et de type (AlGa)InAs.

16. Procédé de fabrication d'un détecteur infrarouge de type SWIR selon l'une des revendications 1 à 15, **caractérisé en ce qu'**il comporte les étapes suivantes :
- la réalisation à la surface d'un substrat de type InP, d'un contact électrique dit inférieur comprenant au moins une couche à gap indirect ;
- la réalisation d'une couche de détection à la surface du contact électrique dit inférieur ;
- la réalisation d'une couche supérieure dopée p en matériau semiconducteur III-V et d'un contact dit supérieur ;
- le retrait dudit substrat de l'empilement préalablement réalisé.

## Patentansprüche

1. Infrarotdetektor auf der Grundlage eines/von Halbleitermaterial(s) des Typs SWIR, welches für kleinere Wellenlängen als ca. 2,5 Mikron empfindlich ist, und eine Aufschichtung von Halbleiterschichten auf Grundlage von Materialien III-V, welche eine Fotodiode des Typs PIN bilden, wobei besagte Aufschichtung mindestens folgendes enthält:
- einen so genannten unteren elektrischen Kontakt, der als optisches Fenster dient;
- eine Detektionsschicht, die für besagte Wellenlängen empfindlich ist; **dadurch gekennzeichnet, dass** der so genannte untere Kontakt freiliegend ist und mindestens eine Schicht aus einem oder mehreren n-dotierten Materalien III-V mit indirektem Spalt vom Typ pseudomorph oder mit Maschenanordnung, mit einem Substrat aus einem Material II-V InP oder GaAs, oder aus einem Silizium- oder Germaniummaterial umfasst.

2. Infrarotdetektor gemäß Anspruch 1, **dadurch gekennzeichnet, dass** die Detektionsschicht aus GalnAs ist.

3. Infrarotdetektor gemäß Anspruch 2, **dadurch gekennzeichnet, dass** der so genannte untere Kontakt eine Legierung auf Grundlage von (Al, As, Sb) umfasst.

4. Infrarotdetektor gemäß Anspruch 2, **dadurch gekennzeichnet, dass** der so genannte untere Kontakt eine Legierung aus AlAs_{0,563}Sb_{0,437}· umfasst.

5. Infrarotdetektor gemäß Anspruch 3, **dadurch gekennzeichnet, dass** der so genannte untere Kontakt mindestens eine Alternierung von Schichten des Typs (Al,Ga)AsSb/(AIGa)lnAs umfasst.

6. Infrarotdetektor gemäß Anspruch 5, **dadurch gekennzeichnet, dass** die Alternierung von Schichten mindestens ca. zehn Schichtpaare des Typs (Al,Ga)AsSb und des Typs (AIGa)lnAs umfasst.

7. Infrarotdetektor gemäß einem der Ansprüche 1 bis 6, **dadurch gekennzeichnet, dass** er außerdem eine Anpassungsschicht des leitfähigen Bands zwischen dem so genannten unteren Kontakt und der sensiblen Schicht umfasst.

8. Infrarotdetektor gemäß Anspruch 7, **dadurch gekennzeichnet, dass** die Anpassungsschicht eine Einheit elementarer Anpassungsschichten umfasst, die eine Alternierung von Schichten des Typs (Al,Ga)AsSb/(AIGa)lnAs aufweisen.

9. Infrarotdetektor gemäß Anspruch 1, **dadurch gekennzeichnet, dass** die Detektionsschicht aus GaAS ist.

10. Infrarotdetektor gemäß Anspruch 1, **dadurch gekennzeichnet, dass** die Detektionsschicht aus InP ist.

11. Infrarotdetektor gemäß Anspruch 9, **dadurch gekennzeichnet, dass** der so genannte untere Kontakt mindestens eine Schicht aus der Legierung AlₓGa₁₋ₓ As umfasst, wobei x zwischen 0,42 und 1 liegt.

12. Infrarotdetektor gemäß Anspruch 10, **dadurch gekennzeichnet, dass** der so genannte untere Kontakt eine Legierung auf Grundlage von (Al, As, Sb) umfasst.

13. Infrarotdetektor gemäß Anspruch 10, **dadurch gekennzeichnet, dass** der so genannte untere Kontakt eine Legierung aus AlAs_{0,563}Sb_{0,437} umfasst.

14. Infrarotdetektor gemäß Anspruch 10, **dadurch gekennzeichnet, dass** der so genannte untere Kontakt mindestens eine Alternierung von Schichten des Typs (Al,Ga)AsSb/(AIGa)lnAs umfasst.

15. Infrarotdetektor gemäß Anspruch 10, **dadurch gekennzeichnet, dass** der so genannte untere Kontakt eine Alternierung von mindestens ca. zehn Schichtpaaren des Typs (Al,Ga)AsSb und des Typs (AIGa)lnAs umfasst.

16. Herstellungsverfahren eines Infrarotdetektors vom Typ SWIR gemäß einem der Ansprüche 1 bis 15, **dadurch gekennzeichnet, dass** es folgende Etappen umfasst:
- Durchführung, auf der Oberfläche eines Substrats des Typs InP, eines elektrischen, so genannten unteren Kontakts, welcher mindestens eine Schicht mit indirektem Spalt umfasst;
- Durchführung einer Detektionsschicht an der Oberfläche des so genannten unteren Kontakts;
- Durchführung einer oberen p-dotierten Schicht aus einem Halbleitermaterial II-V und einem so genannten oberen Kontakt;
- Entfernung des zuvor durchgeführten so genannten Substrats der Schichtung.

## Claims

1. A semiconductor-based SWIR infrared detector sensitive to wavelengths shorter than about 2.5 microns comprising a stack of semiconductor layers based on III-V materials forming a PIN photodiode, said stack comprising at least:
- a naked electrical contact, called a lower electrical contact, serving as an optical window; and
- a detection layer sensitive to said wavelengths;
**characterized in that** the so-called lower contact is naked and comprises at least one layer of indirect-bandgap III-V material(s) doped n-type, pseudomorphic or lattice matched with a substrate being made of a III-V material InP or GaAs or of silicon or germanium.

2. The infrared detector as claimed in claim 1, **characterized in that** the detection layer is made of GaInAs.

3. The infrared detector as claimed in claim 2, **characterized in that** the so-called lower contact comprises an (Al,As,Sb)-based alloy.

4. The infrared detector as claimed in claim 2, **characterized in that** the so-called lower contact comprises an AlAs_{0.563}Sb_{0.437} alloy.

5. The infrared detector as claimed in claim 3, **characterized in that** the so-called lower contact comprises at least one alternation of (Al,Ga)AsSb/(AlGa)InAs layers.

6. The infrared detector as claimed in claim 5, **characterized in that** the alternation of layers comprises at least about ten pairs of (AI,Ga)AsSb and (AlGa)InAs layers.

7. The infrared detector as claimed in one of claims 1 to 6, **characterized in that** it furthermore comprises a layer for matching the conduction bands of the so-called lower contact and the sensitive layer.

8. The infrared detector as claimed in claim 7, **characterized in that** the matching layer comprises a set of elementary matching layers comprising an alternation of (Al,Ga)AsSb/(Al,Ga)InAs layers.

9. The infrared detector as claimed in claim 1, **characterized in that** the detection layer is made of GaAs.

10. The infrared detector as claimed in claim 1, **characterized in that** the detection layer is made of InP.

11. The infrared detector as claimed in claim 9, **characterized in that** the so-called lower contact comprises at least one layer of AlₓGa₁₋ₓAs alloy with x lying between 0.42 and 1.

12. The infrared detector as claimed in claim 10, **characterized in that** the so-called lower contact comprises an (AI,As,Sb)-based alloy.

13. The infrared detector as claimed in claim 10, **characterized in that** the so-called lower contact comprises an AlAs_{0.563}Sb_{0.437} alloy.

14. The infrared detector as claimed in claim 10, **characterized in that** the so-called lower contact comprises at least one alternation of (Al,Ga)AsSb/(AlGa)InAs layers.

15. The infrared detector as claimed in claim 10, **characterized in that** the so-called lower contact comprises at least about ten pairs of (AI,Ga)AsSb and (AlGa)InAs layers.

16. A fabrication process for fabricating an SWIR infrared detector as claimed in one of claims 1 to 15, **characterized in that** it comprises the following steps:
- producing on the surface of an InP substrate, an electrical contact, called a lower contact, comprising at least one layer having an indirect bandgap;
- producing a detection layer on the surface of the so-called lower electrical contact;
- producing a p-type doped upper layer made of a III-V semiconductor and a contact, called the upper contact; and
- removing said substrate from the stack produced beforehand.
